# EUROPEAN PATENT APPLICATION

(11) **EP 4 633 189 A1**
(43) Date of publication of application: **15.10.2025**
(21) Application number: 25165858.9
(22) Date of filing: 25.03.2025
(51) Int. Cl.: H04R 1/02, B81B 7/00, H04R 17/00, H04R 19/00, H04R 19/02, H04R 31/00, H01L 23/538, H05K 1/14, H05K 3/46, H04R 1/06, H01L 23/13

(54) **SEMICONDUCTOR PACKAGE FOR MULTIPLE LOUDSPEAKERS**

(30) Priority: 12.04.2024 US 202418634279
(71) Applicant: STMicroelectronics International N.V., 1228 Plan-les-Ouates, Geneva (CH)
(72) Inventor: MAGGI, Luca, 23852 GARLATE (LC) (IT); DEL SARTO, Marco, 20900 MONZA (IT); GRITTI, Alex, 20871 VIMERCATE (MB) (IT); MAIERNA, Amedeo, 27010 ALBUZZANO (PV) (IT)
(74) Representative: Studio Torta S.p.A.

(57) **Abstract**

A package for multiple MEMS-based speakers in a compact form factor is provided. One package includes: a first rigid section defining a first vent aperture; a second rigid section defining a second vent aperture; a first speaker die attached to the first rigid section and covering the first vent aperture; a second speaker die attached to the second rigid section and covering the second vent aperture; a first flexible section attached between and providing electrical continuity between the first rigid section and the second rigid section; and a spacer defining an acoustic port, where the first rigid section is attached to a first side of the spacer, and the second rigid section is attached to a second side of the spacer, where the first speaker die faces the second speaker die.

## Description

### TECHNOLOGICAL FIELD

The present invention relates to a package, a method of forming a package and to a system including the package; more particularly, the present invention relates to packaging of multiple MEMS-based loudspeakers in a compact form factor that improves manufacturability and enhances audio qualities of the loudspeakers.

### BACKGROUND

Using speakers to generate audio has wide applicability to a variety of use cases. While relatively larger speakers can provide ample sound to fill an environment, challenges arise for speakers used in smaller applications. For example, speakers used in ear-bud style headphones or in mobile devices such as cellular phones require substantial audio output from very small form factors. Micro-electro-mechanical systems (MEMS) speakers are very small speaker packages that are useful in a wide variety of applications requiring speakers having small form factors. These speakers function in a manner consistent with conventional speakers, by moving air according to a frequency the speaker is to generate a noise audible to an ear or an electronic receiver (e.g., microphone). The volume of air moved/displaced has a direct impact on the volume and power a speaker can generate. As these speakers are relatively very small in size, the volume of air moved is relatively small. Thus, some embodiments demand multiple MEMS speakers to achieve the volume of air moved and audio volume desired for a particular device.

Due to packaging size constraints of many applications, MEMS speaker packaging is challenging given space constraints and the physical properties of the materials used for speakers, along with the requisite acoustic functionalities for a given device.

### BRIEF SUMMARY

The present invention relates to a package, a method of forming a package, and a system comprising the package, as defined in the annexed claims.

Various embodiments described herein relate generally to packaging of multiple loudspeakers, and more particularly, to an apparatus, system, and method for packaging of multiple MEMS-based loudspeakers in a compact form factor that improves manufacturability and enhances audio qualities of the loudspeakers.

Embodiments provided herein include a package including: a first rigid section defining a first vent aperture; a second rigid section defining a second vent aperture; a first speaker die attached to the first rigid section and covering the first vent aperture; a second speaker die attached to the second rigid section and covering the second vent aperture; a first flexible section attached between and providing electrical continuity between the first rigid section and the second rigid section; and a spacer defining an acoustic port, where the first rigid section is attached to a first side of the spacer, and the second rigid section is attached to a second side of the spacer, where the first speaker die faces the second speaker die.

According to some embodiments, the first rigid section, the second rigid section, and the spacer define an acoustic chamber, where sound from the acoustic chamber is directed through the acoustic port defined in the spacer. The package of some embodiments further includes: a first cap attached to the first rigid section, where the first speaker die is attached to a first side of the first rigid section, where the first cap is attached to a second side of the first rigid section, opposite the first side; and a second cap attached to the second rigid section, where the second speaker die is attached to a first side of the second rigid section, where the second cap is attached to a second side of the second rigid section, opposite the first side. According to certain embodiments, the first cap defines a first cavity between the first cap and the second side of the first rigid section and the second cap defines a second cavity between the second cap and the second side of the second rigid section. According to some embodiments, the first cavity is isolated from the acoustic chamber, and wherein the second cavity is isolated from the acoustic chamber.

According to the package of some embodiments, the first rigid section defines a first trench around the first vent aperture, the second rigid section defines a second trench around the second vent aperture, where the first speaker die is attached to the first rigid section using adhesive deposited in the first trench, and the second speaker die is attached to the second rigid section using adhesive deposited in the second trench. The package of certain embodiments further includes a third rigid section and a second flexible section attached between and providing electrical continuity between the first rigid section and the third rigid section.

The package of some embodiments further includes a connector attached to the third rigid section, where the connector is in electrical communication with the first speaker die and the second speaker die. The third rigid section of some embodiments includes electrical leads, where the electrical leads are in electrical communication with the first speaker die and the second speaker die. According to some embodiments, a first electrical lead of the electrical leads is in communication with the first speaker die via the second flexible section, and a second electrical lead of the electrical leads is in communication with the second speaker die via the second flexible section and the first flexible section. According to certain embodiments, the first speaker die, and the second speaker die each comprise a micro-electro-mechanical system (MEMS) speaker die.

Embodiments provided herein include a method of forming a package including: attaching a first speaker die to a first rigid section over a first vent aperture through the first rigid section; attaching a second speaker die to a second rigid section over a second vent aperture through the second rigid section, where the first rigid section is attached to the second rigid section with a first flexible section; attaching the first rigid section to a first side of a spacer; and attaching the second rigid section to a second side of the spacer by flexing the first flexible section to form an acoustic chamber between the first rigid section and the second rigid section and bounded by the spacer.

The method of some embodiments further includes: attaching a first cap to the first rigid section, where the first speaker die is attached to a first side of the first rigid section, where the first cap is attached to a second side of the first rigid section, opposite the first side; and attaching a second cap to the second rigid section, where the second speaker die is attached to a first side of the second rigid section, where the second cap is attached to a second side of the second rigid section, opposite the first side. According to some embodiments, the first cap defines a first cavity between the first cap and the second side of the first rigid section and the second cap defines a second cavity between the second cap and the second side of the second rigid section. According to certain embodiments, the first cavity is isolated from the acoustic chamber and the second cavity is isolated from the acoustic chamber. Attaching the first speaker die to the first rigid section over the first vent aperture includes, in some embodiments, depositing adhesive in a trench surrounding the first vent aperture and attaching a frame of the first speaker die to the adhesive.

Embodiments provided herein include a micro-electro-mechanical (MEMS) speaker system including: a first rigid section defining a first vent aperture; a second rigid section defining a second vent aperture; a third rigid section; a first speaker die attached to the first rigid section and covering the first vent aperture; a second speaker die attached to the second rigid section and covering the second vent aperture; a first flexible section attached between and providing electrical continuity between the first rigid section and the second rigid section; a second flexible section attached between and providing electrical continuity between the first rigid section and the third rigid section, where electrical connections on the third rigid section are in electrical communication with the first speaker die via the second flexible section and the second speaker die via the first flexible section and the second flexible section; and a spacer defining an acoustic port, where the first rigid section is attached to a first side of the spacer, and the second rigid section is attached to a second side of the spacer, where the first speaker die faces the second speaker die.

According to some embodiments, the first rigid section, the second rigid section, the third rigid section, the first flexible section, and the second flexible section are formed to be coplanar for attachment of the first speaker die, the second speaker die, and the spacer. According to certain embodiments, the first speaker die is wire bonded to solder pads of the first rigid section, and the second speaker die is wire bonded to solder pads of the second rigid section. The first rigid section, the second rigid section, and the spacer define a circular profile in some embodiments.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF SUMMARY OF THE DRAWINGS

Having thus described certain example embodiments of the present disclosure in general terms, reference will now be made to the accompanying drawings, which are not necessarily drawn to scale, and wherein:
Figure 1 illustrates a portion of package for speakers according to an example embodiment of the present disclosure;
Figure 2 illustrates attachment of a connector to the portion of the package of Figure 1 according to example embodiments of the present disclosure;
Figure 3 illustrates deposition of a glue pattern around a vent aperture according to an example embodiment of the present disclosure;
Figure 4 illustrates a trench in a rigid section for receiving a glue pattern according to an example embodiment of the present disclosure;
Figure 5 illustrates attachment of MEMS speaker dies to rigid sections of a package according to an example embodiment of the present disclosure;
Figure 6 illustrates deposition of spacer glue patterns according to an example embodiment of the present disclosure;
Figure 7 illustrates attachment of a spacer to a spacer glue pattern according to an example embodiment of the present disclosure;
Figure 8 illustrates a folding of a second rigid section over a first rigid section along a first flexible section according to an example embodiment of the present disclosure;
Figure 9 illustrates the first rigid section and second rigid section attached on opposite sides to the spacer according to an example embodiment of the present disclosure;
Figure 10 illustrates a view of the package depicting an acoustic aperture in the spacer according to an example embodiment of the present disclosure;
Figure 11 illustrates a back side of first, second, and third rigid sections before assembly of the package according to an example embodiment of the present disclosure;
Figure 12 illustrates a folding of a second rigid section over a first rigid section along a first flexible section according to an example embodiment of the present disclosure;
Figure 13 illustrates the first rigid section and second rigid section attached on opposite sides to the spacer with caps creating back cavities for the speakers according to an example embodiment of the present disclosure;
Figure 14 illustrates a view of the package depicting an acoustic aperture in the spacer according to an example embodiment of the present disclosure;
Figure 15 illustrates a package having wire connections directly on the first rigid section according to an example embodiment of the present disclosure;
Figure 16 illustrates a pair of packages arranged in a stacked configuration according to an example embodiment of the present disclosure;
Figure 17 illustrates a circular embodiment of the package according to an example embodiment of the present disclosure;
Figure 18 illustrates another view of a circular embodiment of the package according to an example embodiment of the present disclosure;
Figure 19 illustrates another view of a circular embodiment of the package depicting the acoustic aperture according to an example embodiment of the present disclosure;
Figure 20 illustrates a section view of a package according to an example embodiment of the present disclosure.

### DETAILED DESCRIPTION

Some embodiments of the present disclosure will now be described more fully herein with reference to the accompanying drawings, in which some, but not all, embodiments of the disclosure are shown. Indeed, various embodiments of the disclosure can be embodied in many different forms and should not be construed as limited to the embodiments set forth herein; rather, these embodiments are provided so that this disclosure will satisfy applicable legal requirements. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase can be included in at least one embodiment of the present disclosure and can be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature can either be optionally included in some embodiments, or it can be excluded.

The use of the term "circuitry" as used herein with respect to components of a system or an apparatus should be understood to include particular hardware configured to perform the functions associated with the particular circuitry as described herein. The term "circuitry" should be understood broadly to include hardware and, in some embodiments, software for configuring the hardware. For example, in some embodiments, "circuitry" can include processing circuitry, communications circuitry, input/output circuitry, and the like. In some embodiments, other elements can provide or supplement the functionality of particular circuitry.

Various embodiments of the present disclosure are directed to packaging of multiple loudspeakers, and more particularly, to an apparatus, system, and method for packaging of multiple MEMS-based loudspeakers in a compact form factor that improves manufacturability and enhances audio qualities of the loudspeakers.

Semiconductor packages including MEMS-based speakers continue to shrink in size and be utilized in environments with increasing constraints on size, such as in mobile phones, portable electronics, and the like. Shrinking semiconductor packages require all components of the overall package to decrease in size, where some components possess physical limitations on size due to one or more of existing manufacturing technology, production costs, structural requirements, or the like. An effective way of reducing the overall size of a semiconductor package is to eliminate components if there is a possible way to otherwise provide the functionality of the eliminated components. These components can include packaging components when an improvement in the overall packaging arrangement can be leveraged.

Wafer-level packaging provides an efficient manufacturing process through which an integrated circuits are fabricated, and components of the integrated circuit are attached to the integrated circuit before it is singulated into an individual circuit. The components such as top and bottom layers of the packaging and solder bumps are attached to the integrated circuit through a process that does not require handling of individual integrated circuits. This process enables efficient and consistent packaging assembly to the integrated circuit without requiring an individual integrated circuit to be handled and aligned in order to assemble the components thereon. Fan-out wafer-level packaging employs a similar technique; however, the integrated circuit is singulated before at least some components of the wafer-level package are attached to the integrated circuit. Fan-out wafer-level packaging enables portions of the overall semiconductor package to be larger than the integrated circuit itself (e.g., the die cut wafer). Embodiments described herein can be employed in wafer-level packaging and in fan-out wafer-level packaging with some modification to the manufacturing process. However, the end product remains essentially the same.

Electronic devices, such as mobile phones or in-ear speakers (e.g., earbuds), are highly portable and frequently carried throughout a user's day. As such, the size of a mobile phone or other portable electronic device is critical to the portability and use of such a device. These electronic devices have very high levels of functionality and are required to be robustly designed to stand up to frequent use and often, unintentional abuse and wear. Thus, the structure of theses electronic devices requires some degree of rigidity while maintaining a small form factor. The substantially rigid chassis of an electronic device which carries the hardware components thereof (e.g., the sensors, communications modules, speakers, cameras, screen, etc.) becomes a substantial component of the overall size, which limits the available space for the hardware components. The competing hardware components need to be sized to fit within the small form factor, otherwise components will be omitted, which adversely impacts functionality and desirability of the electronic device. As such, a small form factor package for one or more sensors or speakers is highly desirable, and smaller components enable the electronic device form factor to be made smaller and/or enables the inclusion of more components increasing the functionality of the electronic device.

MEMS-based speakers are desirable for use in compact form-factor devices, such as in-ear headphones or earbuds, mobile device speakers (e.g., cellular phones), or other devices where the overall package size is relatively small. Accordingly, MEMS-based speakers are generally very small. However, as sound generation through traditional techniques of driving air or soundwaves at specific frequencies, the volume of air moved directly correlates with the audible volume of the sound. Further, when speakers are driven at their physical limits, sound quality and frequency response is diminished. Thus, while MEMS-based speakers provide a small form-factor speaker, they also tend to move less air and consequently have lower audible volume capabilities.

To improve upon the challenge of audio volume with small, MEMS-based speakers, multiple speakers are formed together in a package. However, more speakers generally require more space, such that spatial constraints provide a further challenge to generating substantial audio volume with MEMS speakers. A MEMS speaker package generally requires a printed circuit board (PCB), a MEMS speaker die, and a diaphragm. The package further generally requires a housing of some sort along with an audio chamber for the speaker package. The diaphragm moves as it drives air to produce sound, such that clearances are needed for the diaphragm to freely travel. Increasing a volume of air moved to increase an audio volume from a device by multiplying the number of MEMS speaker packages dramatically increases the overall package size of the speakers, such that efficiencies of the small MEMS speaker are diminished.

Merely increasing the number of speaker packages multiplies the total volume of speaker components to multiply the amount of air moved to increase volume. Embodiments described herein provide a single package with two or more loudspeakers that provides an efficient overall package that serves to multiply the volume of air that can be moved, while not multiplying the total volume of the speaker package at the same ratio.

Embodiments of the present disclosure provide a single package with two or more MEMS speakers that are produced on a substrate and manipulated to face each other. The embodiments provide a rigid flex substrate for a MEMS loudspeaker die to attach to along with a single set of electrical connections. According to an example embodiment, two MEMS loudspeaker dies are formed on the same substrate, and the substrate is folded over to have the loudspeaker dies face one another. A spacer can be employed between the facing loudspeaker dies to provide a sufficient front acoustic chamber. Embodiments are suitable for high volume production of a package for multiple loudspeakers that has a small form factor and fewer electrical connections than conventional solutions.

The substrate of embodiments described herein include a pair of rigid sections connected by a flex section. In some embodiments, the substrate further includes a third rigid section connected to one of the other two rigid sections by another flex section, where the third rigid section providing a substrate for a connector to connect the speaker system with a driving circuit.

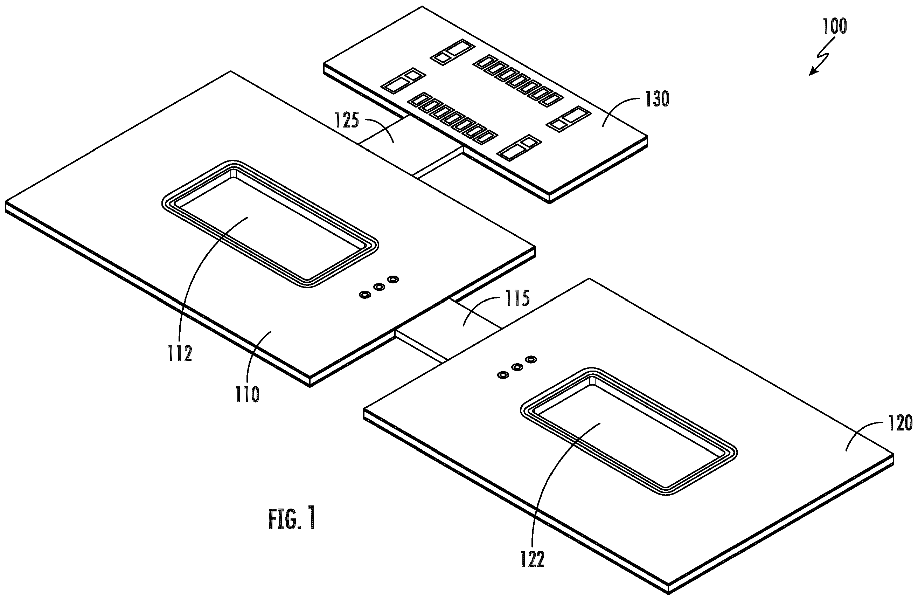

Figure 1 illustrates a package 100 of example embodiments described herein that includes three rigid sections connected by two flexible sections. As shown the first rigid section 110 is connected to the second rigid section 120 by first flexible section 115. The third rigid section 130 is connected to the first rigid section 110 by the second flexible connection 125. In the illustrated embodiment, the first rigid section 110 includes a first vent aperture 112 and the second rigid section 120 include a second vent aperture 122 for the MEMS speaker diaphragms, and the third rigid section 130 is dedicated to a connector for electrical signals from a driving circuit. Each of the rigid sections of the illustrated embodiment are printed circuit boards or wafer-level semiconductors.

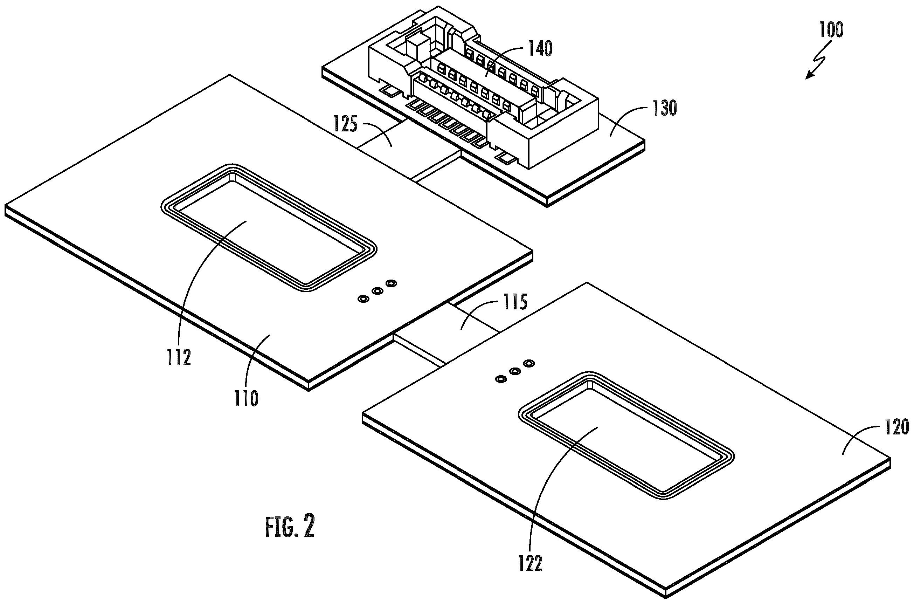

Figure 2 illustrates the attachment of a connector 140 to the third rigid section 130. This connector 140 can be attached using solder paste deposition on the third rigid section followed by application of the connector 140 to the third rigid section 130. The connector 140 provides a convenient electrical connection to a device, such as a mobile phone, for assembly of the device and for possible service and interchanging of the package 100.

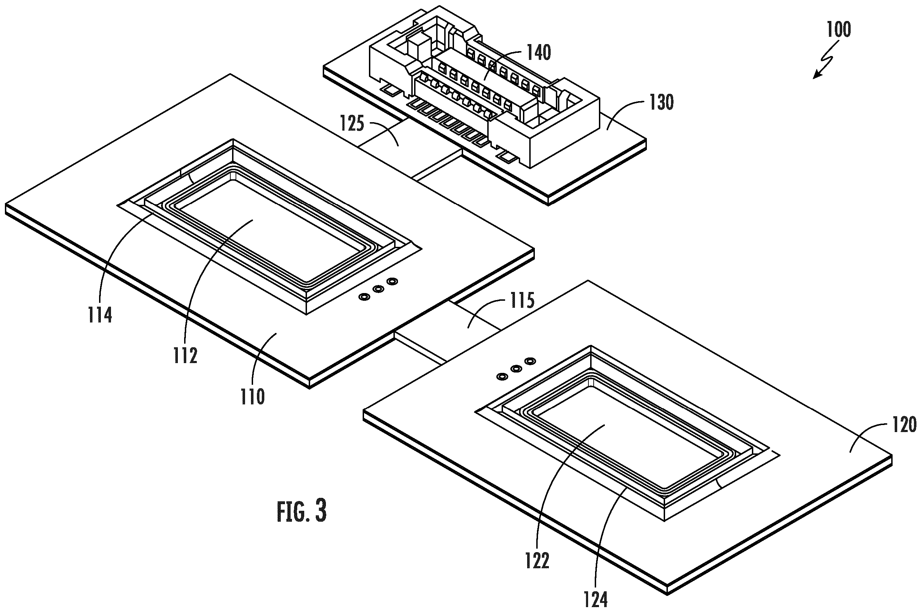

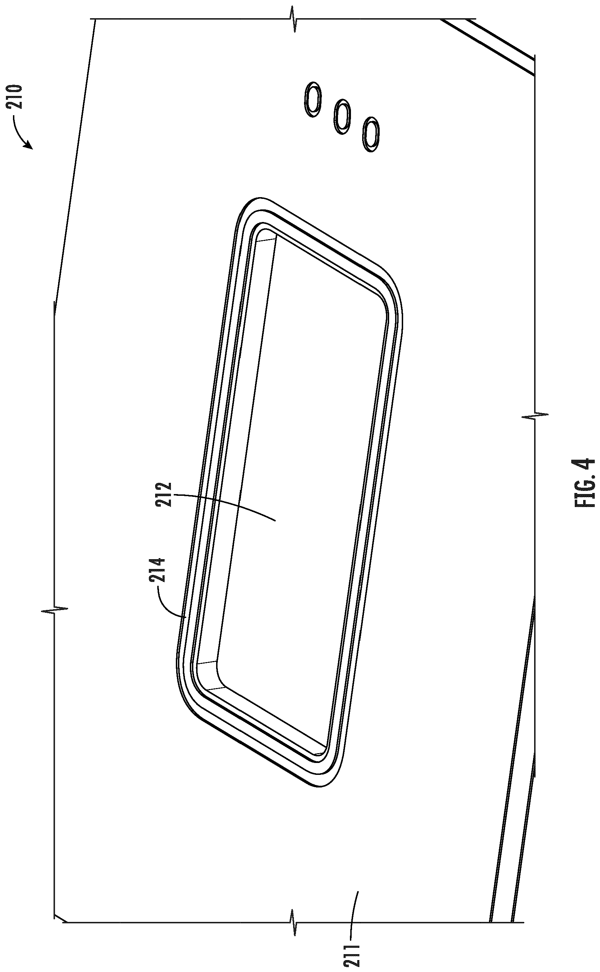

Figure 3 illustrates deposition of glue or adhesive around the first vent aperture 112 in a first glue pattern 114, and deposition of glue or adhesive around the second vent aperture 122 in a second glue pattern 124. The glue patterns can be deposited based on a trench formed in a solder mask on the rigid sections, where the trench in the solder mask can help preclude deposited glue from reaching the vent aperture and compromising the quality and performance of the speaker. Figure 4 illustrates an example trench 214 in a solder mask 211 of a rigid substrate 210 surrounding the vent aperture 212. The trench 214 provides a flow path for the deposited glue which also encourages more even deposition around the vent aperture 212.

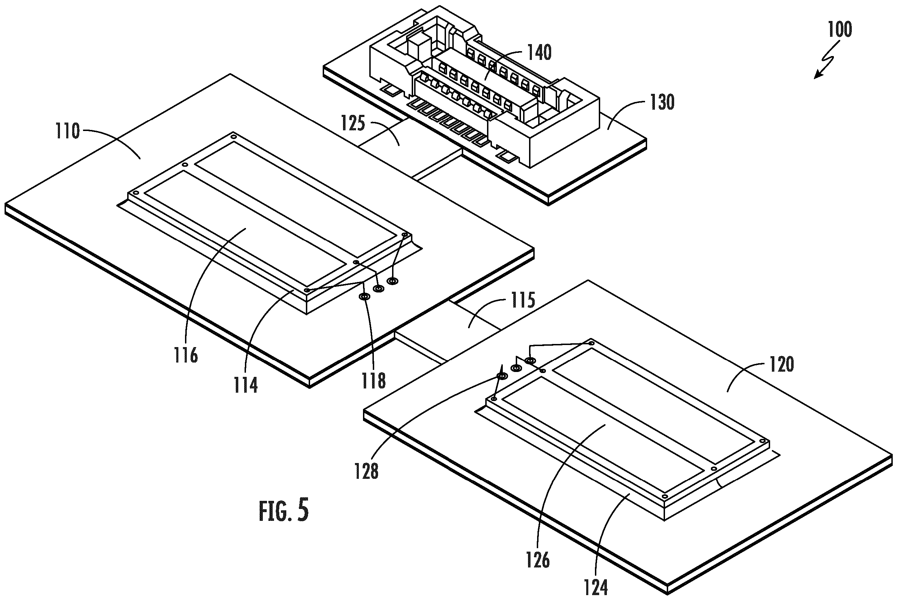

Figure 5 illustrates the attachment of a first MEMS speaker die 116 to the first glue pattern 114 of the first rigid section 110 and attachment of a second MEMS speaker die 126 to the second glue pattern 124 of the second rigid section 120. The MEMS speaker dies include the diaphragms of the speakers that move responsive to a driving signal and consequently move air generating an audible sound. This requires the MEMS speaker dies to have a clearance above and below the diaphragm portion to allow this movement. Interference with the movement of the diaphragm can result in distortion of audio output and frequency limits of audio output. The MEMS speaker dies include a frame about the diaphragm which is the portion to which the glue patterns adhere, leaving the diaphragms free to move and produce audio signals. Each MEMS speaker die package needs to have acoustic isolation on either side of the MEMS speaker die. A consistent glue pattern is essential to ensure acoustic isolation between a front side of the MEMS speaker die and back side of the MEMS speaker die. In the illustrated embodiment of Figure 5, the front side of each of the depicted MEMS speaker dies are facing upwardly, with a back side of the MEMS speaker dies facing toward a respective vent aperture in the rigid sections.

The MEMS speaker dies are wire bonded to solder pads on a respective rigid section. As shown, the first MEMS speaker die is wire bonded to solder pads 118 of the first rigid section 110, while the second MEMS speaker die is wire bonded to solder pads 128 of the second rigid section 120. The wire bonding of the MEMS speaker dies ensures they are in electrical communication with the connector 140 that is soldered to the third rigid section 130. The solder pads 128 of the second rigid section 120 are in electrical communication with the first rigid section 110 across the first flexible section 115. The solder pads 118 of the first rigid section 110 and the solder pads 128 of the second rigid section 120 are in electrical communication with solder pads of the third rigid section 130 via second flexible section 125. This enables a connector from a driving circuit connected to connector 140 to provide electrical signals to each of the first MEMS speaker die 116 and the second MEMS speaker die 118.

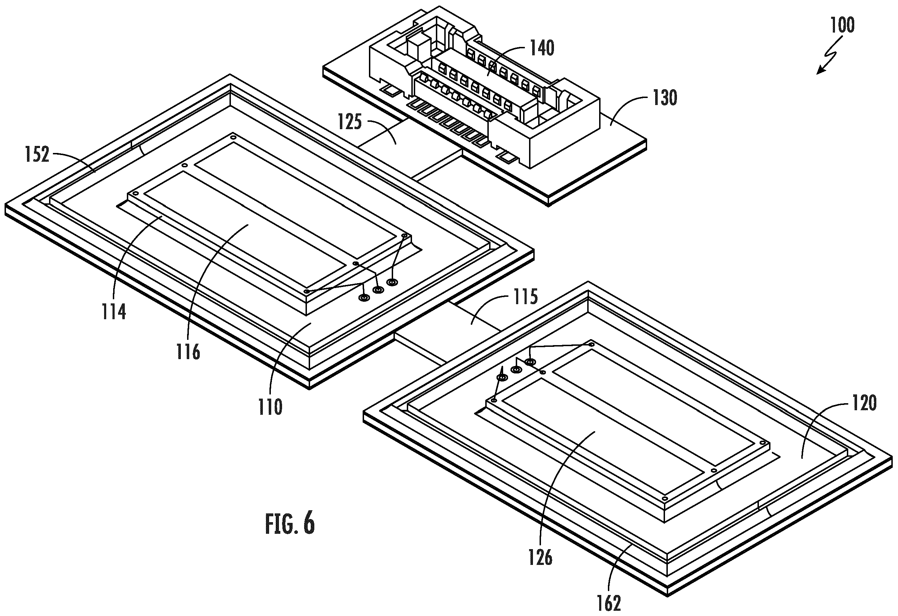

Each MEMS speaker needs to have an acoustic chamber on a front side of the MEMS speaker die. As shown in Figure 6, a first spacer glue pattern 152 is deposited on the first rigid section 110, and a second spacer glue pattern 162 is deposited on the second rigid section 120. The first rigid section 110 and the second rigid section 120 can include a glue trench in the solder mask for a respective spacer glue pattern. However, as the spacer glue patterns are not proximate the vent aperture or the MEMS speaker die, this is not essential. The trench in the solder mask can benefit the attachment of the spacer by providing an improved glue seal when the spacer is attached as described further below and provides an improved acoustic isolation of an acoustic chamber by lessening a likelihood of acoustic air leakage from an unintended location of the spacer.

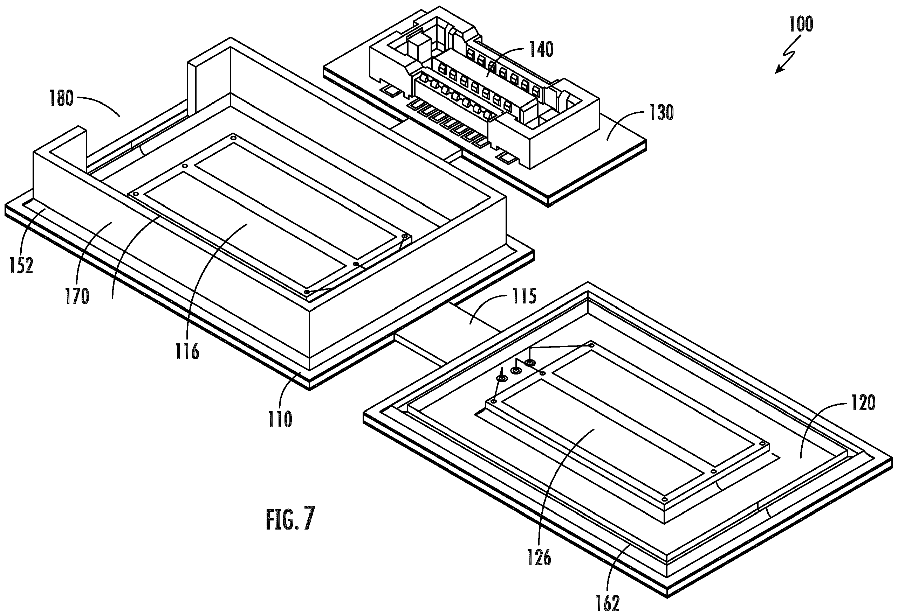

Figure 7 illustrates a spacer 170 attached to the first spacer glue pattern 152 on the first rigid section 110. The spacer 170 includes an acoustic port 180. In the illustrated embodiment, the acoustic port 180 is a discontinuity in the spacer or a "break" with no connection for the spacer across the acoustic port 180. In such an embodiment, the first spacer glue pattern 152 and the second spacer glue pattern 162 can also include a break at the location of the acoustic port 180. According to some embodiments, the acoustic port is formed as an aperture within the spacer where the acoustic port is not a complete discontinuity or break in the spacer 170.

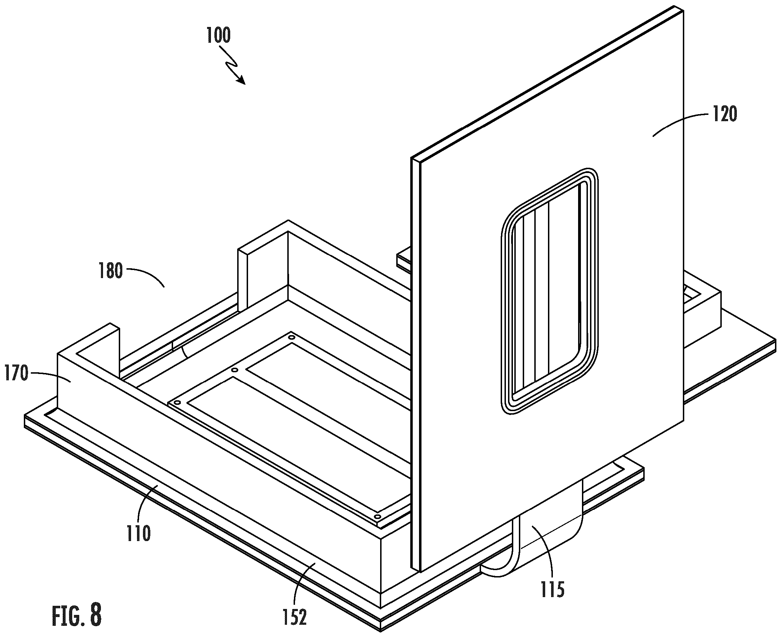

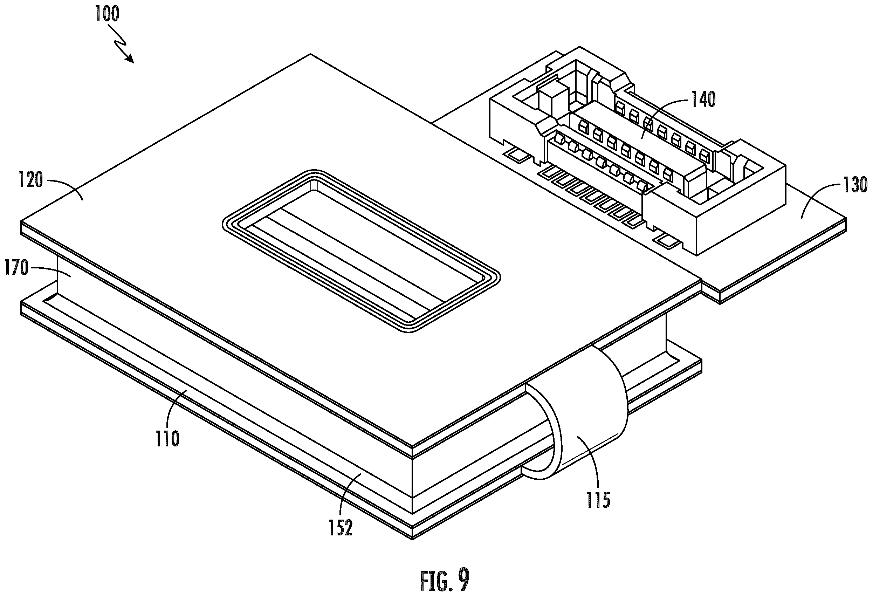

Figure 8 illustrates the second rigid section 120 being moved to overlie the first rigid section 110 and attach to the spacer 170. As shown, the first flexible section 115 provides the flexibility to accomplish this motion, while also maintaining electrical continuity between the first rigid section 110 and the second rigid section 120. Figure 9 illustrates second rigid section 120 folded to completely overlie the first rigid section 110. The second rigid section 120 attaches to the spacer 170, opposite the first rigid section 110, via the second spacer glue pattern 162 not visible in Figure 9.

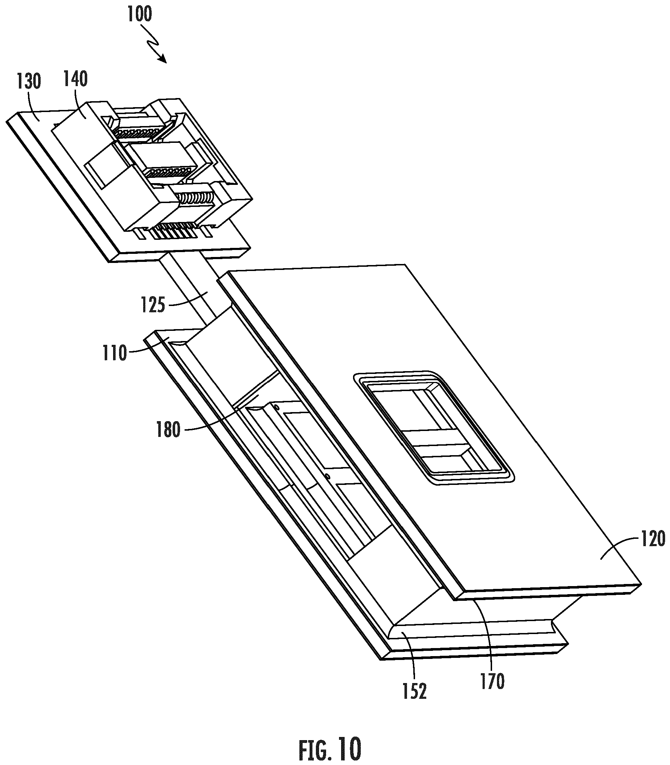

Figure 10 illustrates another view of the package 100 looking toward the acoustic port 180 in the spacer 170. As depicted, the first rigid section 110, the second rigid section 120, and the spacer 170 form a chamber with the acoustic port 180 being the only path for air to move to/from the chamber. This acoustic port 180 provides the audio output from the pair of MEMS speakers in a compact form factor that benefits from two MEMS speakers in a single package that is efficient and effectively packaged. The package 100 as shown in Figure 10 is suitable for installation in the depicted form in many cases. The second flexible section 125 enables flexibility in the device when the package 100 is installed. Further, the flexibility of the second flexible section 125 enables movement of the connector 140 and the third rigid section 130 when a mating connector is attached and/or removed such that the attachment/removal of a connector is less likely to damage the MEMS speaker assemblies of the package than if the second flexible connection 125 were rigid attachment between the first rigid section 110 and the third rigid section 130.

While the illustrated embodiment of Figure 10 is suitable for use in many applications, some applications will require back chambers for the speaker assemblies to cover over the vent apertures. Infinite back chambers, where there is no cover over the vent apertures in the package, are suitable for devices such as augmented reality glasses for example. However, certain devices, such as in-ear headphones or earbuds require a finite back chamber.

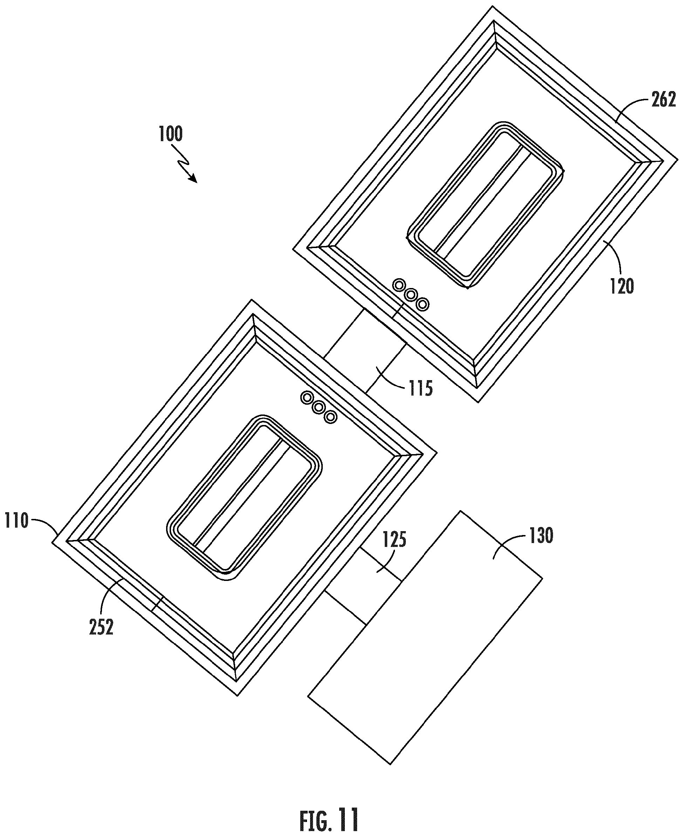

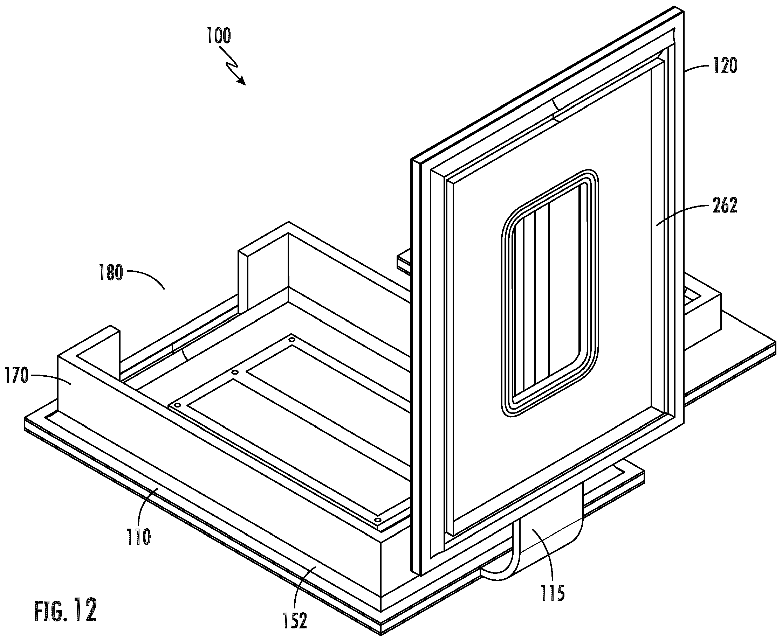

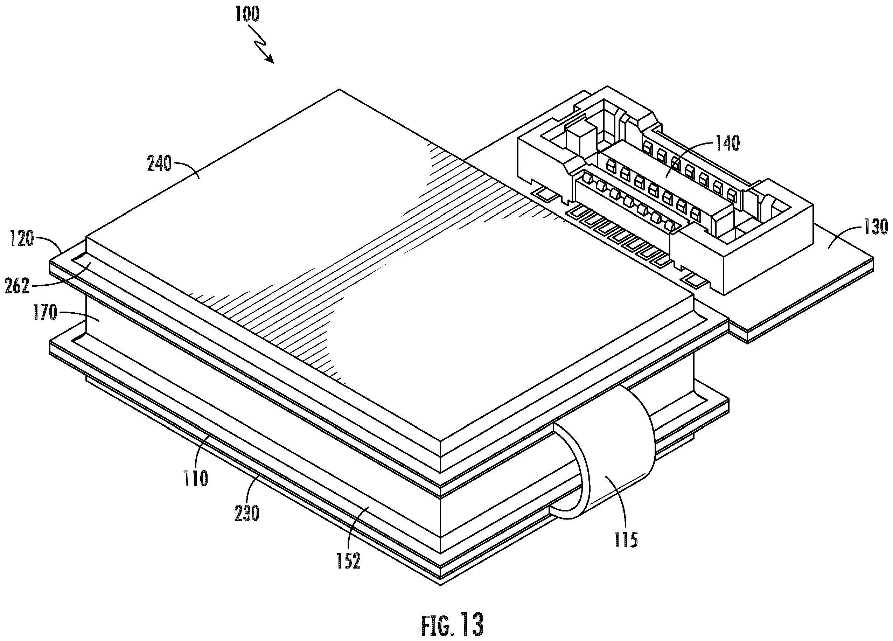

Figure 11 illustrates the package 100 in the unfolded state, as found in Figure 7; however, a first back chamber glue pattern 252 has been deposited as has a second back chamber glue pattern 262. Figure 12 illustrates the folding process similar to that of Figure 8, whereby the second rigid section 120 is folded over onto the spacer 170 by virtue of the first flexible section 115. Figure 13 illustrates the second rigid portion 120 folded over and secured to the spacer 170 as found in Figure 9. However, a second cap 240 has been secured to the second rigid section 120 forming a second back chamber by way of the second back chamber glue pattern 262. A first cap 230 is secured to a back side of the first rigid section 110 to form a first back chamber by way of the first back chamber glue pattern. The first cap 230 and the second cap 240 provide a chamber on a back side of the vent apertures of the rigid sections. The first cap and the second cap can be formed of plastic, metal, or even using a B-stage adhesive.

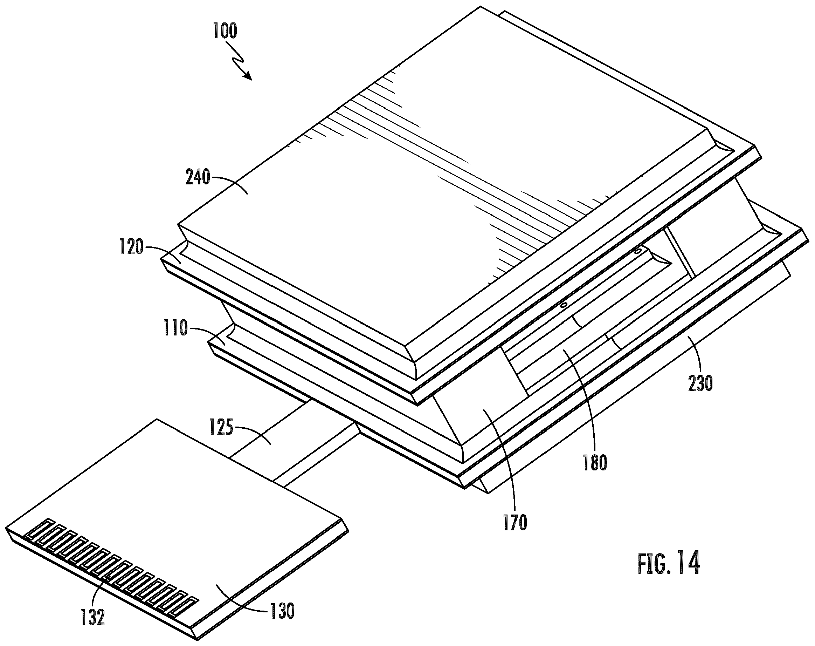

While a connector 140 is depicted in the aforementioned illustrated embodiments mounted to the third rigid section 130, embodiments do not require such a connector and instead use the third rigid section 130 as a connection point. Figure 14 illustrates such an embodiment where the third rigid section 130 includes a plurality of connection pads 132, such that the third rigid section 130 can be inserted into a connector to connect the package 100 to a driving circuit of a device. In this embodiment, the second rigid section 125 provides the flexibility of installation of the third rigid section 130 into a receiving connector (not shown) and positioning of the package 100 within a device while lessening the risk of damage to the package during the connection of the package to a driving circuit.

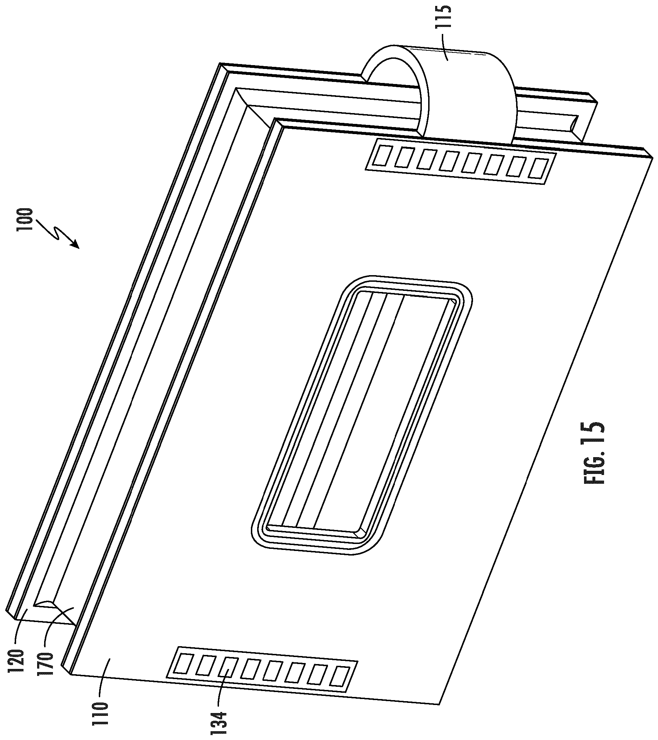

Figure 15 illustrates another example embodiment of the package 100 where no third rigid section is necessary. The package of Figure 15 does not require back chambers or caps such that a back surface of the first rigid section 110 can include contact pads 134 to which a connector can attach or to which wires can be soldered from the driving circuit to drive the MEMS speakers of the package 100.

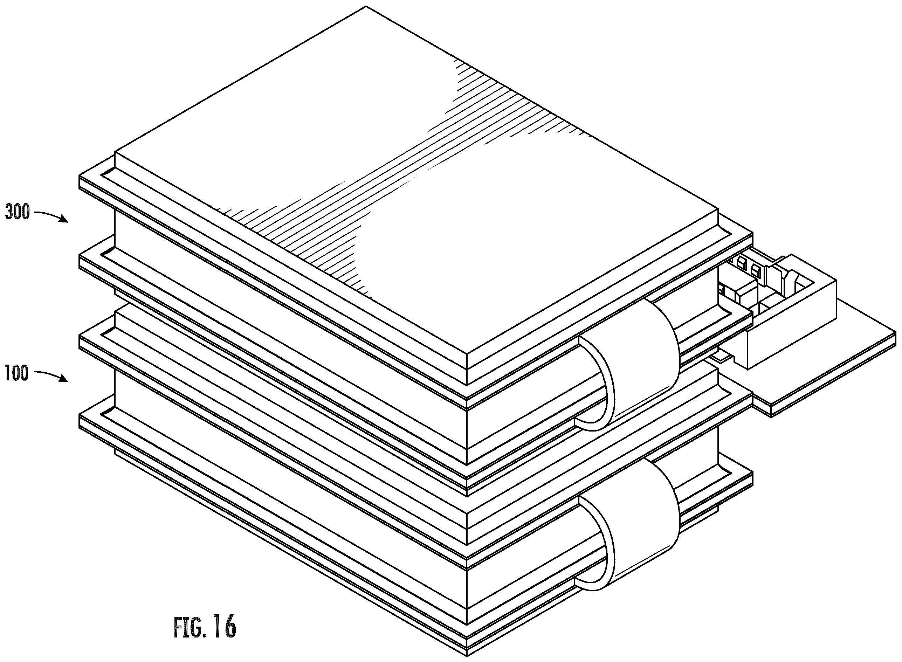

Embodiments described herein provide an improved package for multiple MEMS speakers having an efficient package size. Further, embodiments described herein can be modular in nature, such that multiple packages can be combined according to the device for which the speakers are designed. Figure 16 illustrates an example embodiment of two packages in a stacked arrangement to provide four MEMS speakers combining to produce sound from two acoustic apertures. In this stacked arrangement, a second package 300 is stacked atop a first package 100. The speaker packages of the illustrated embodiment include back cavities formed by caps as found in Figure 13. This enables the stacking arrangement with a cap of the first package 100 being able to have the cap of a second package 300 stacked thereon. The two packages can be adhered to one another or mechanically connected to form the multi-package arrangement.

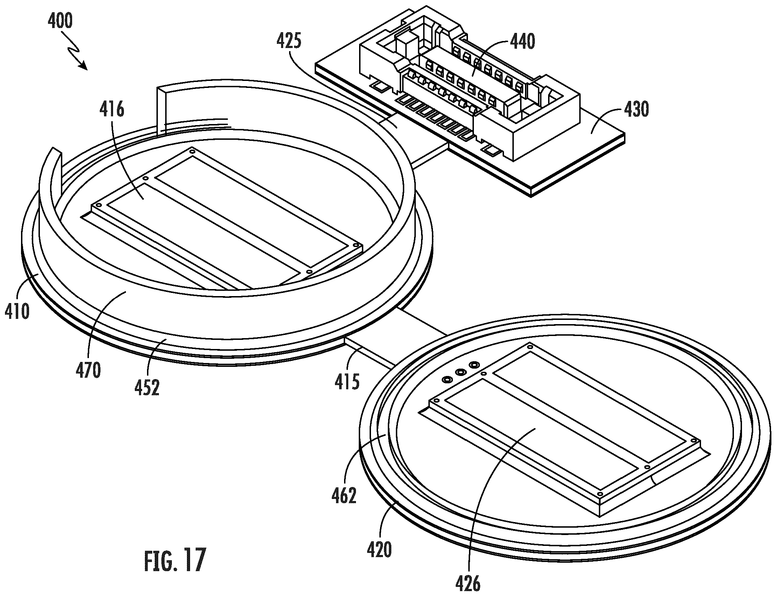

While the illustrated embodiments described above have a generally rectangular form factor, the package of various embodiments can include different shapes. For example, Figure 17 illustrates a package 400 having a circular form factor. The components of the illustrated embodiment of Figure 17 are similar to those of the aforementioned embodiments. As shown, a first rigid section 410 is connected to a second rigid section 420 by a first flexible section 415. A third rigid section 430 is connected to the first rigid section 410 by a second flexible section 425. The third rigid section 430 of the illustrated embodiment includes a connector 440. A spacer 470 is adhered to the first rigid section 110 by a first spacer glue pattern 452, and a second spacer glue pattern 462 is deposited on the second rigid substrate 420.

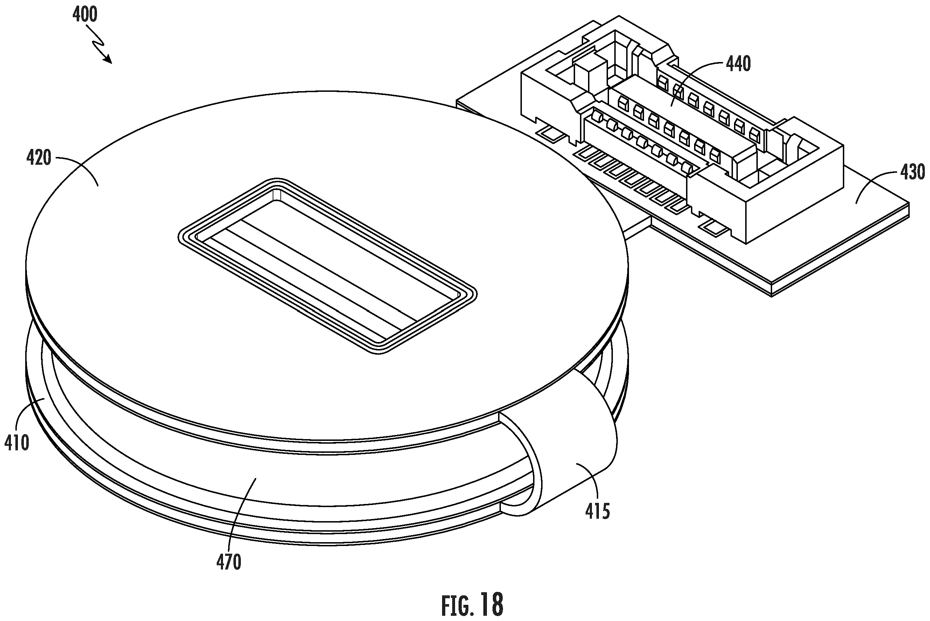

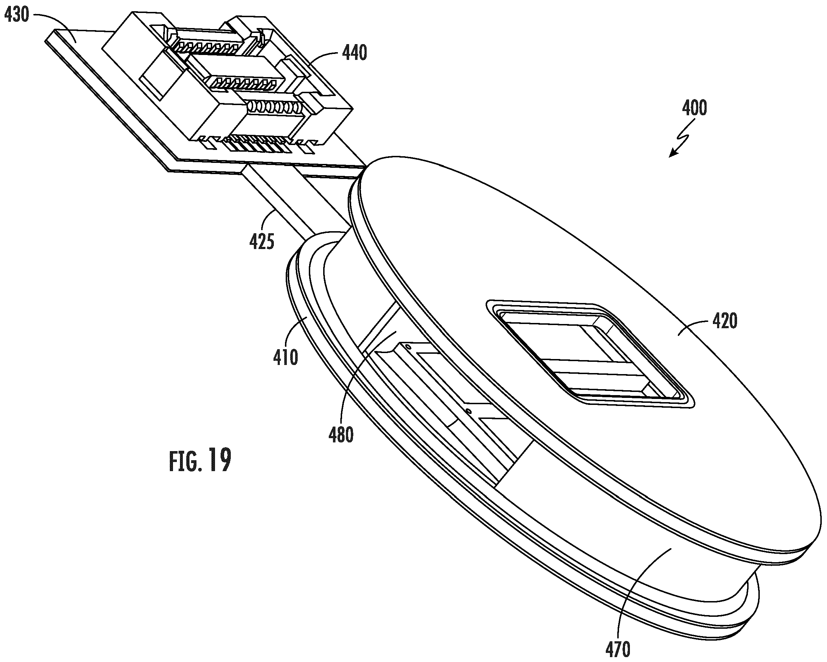

As with earlier described embodiments, the second rigid section 420 can be folded over onto the spacer 470 attached to the first rigid section 410 as shown in Figure 18 through the flexibility of the first flexible section 415. Figure 19 illustrates a rotated version of the package 400 of Figure 18 with the acoustic port 480 formed in the spacer 470. The rigid sections can be of any two-dimensional shape that can accommodate the vent apertures and the MEMS speaker die. The different package shapes can be used to fit within certain devices or to abut certain components within an arrangement of components of a device package. Further, the shape of the package can influence sound quality and fidelity. As such, certain shapes may be better suited to certain applications to provide accurate reproduction of sounds.

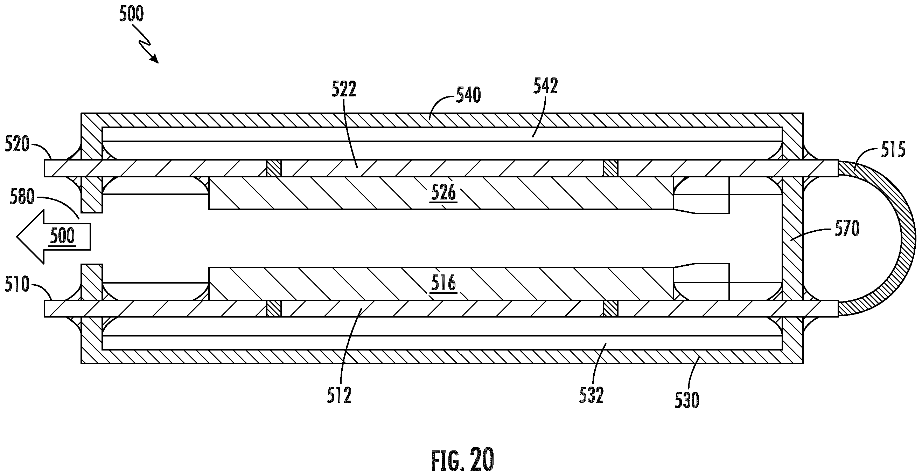

Figure 20 illustrates a section view of a package 500 for a pair of MEMS speakers as described herein. As shown, a first rigid section 510 includes a first MEMS speaker die 516 attached to the first rigid section over a first vent aperture 512. A second MEMS speaker die 526 is attached to a second rigid section 520 over a second vent aperture 522. The first rigid section 510 is attached to a first side of the spacer 570, and the second rigid section 520 is attached to a second side of the spacer. The spacer includes acoustic port 580 through which the sound is directed along arrow 550. The first rigid section 510 is attached to the second rigid section 520 by flexible section 515. Also illustrated in the embodiment of Figure 20 is a first cap 530 attached to the first rigid section 510 to form a first back cavity 532, and a second cap 540 attached to the second rigid section 520 to form a second back cavity 542. This package 500 provides a superior arrangement for a pair of MEMS speakers in a compact form factor.

When a speaker is packaged, there is a need to have acoustic isolation between the front and the back chambers. When two speakers are facing each other, as described in embodiments herein, the isolation between the chambers is even more critical. The overall performance is enhanced by a proper distance between the two facing speaker dies. The front chamber is shared between the two facing speakers. Embodiments of the present disclosure employ a spacer that ensures a consistent and accurate spacing between the MEMS speakers, ensuring consistency among packages and devices into which the packages are installed.

While this specification contains many specific embodiments and implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

While this detailed description has set forth some embodiments of the present invention, the appended claims cover other embodiments of the present invention which differ from the described embodiments according to various modifications and improvements.

Within the appended claims, unless the specific term "means for" or "step for" is used within a given claim, it is not intended that the claim be interpreted under 35 U.S.C. § 112, paragraph 6.

## Claims

1. A package (100) comprising:
a first rigid section (110; 120) defining a first vent aperture (112; 122);
a second rigid section (120; 110) defining a second vent aperture (122; 112);
a first speaker die (116; 126) attached to the first rigid section and covering the first vent aperture;
a second speaker die (126; 116) attached to the second rigid section and covering the second vent aperture;
a first flexible section (115) attached between and providing electrical continuity between the first rigid section and the second rigid section; and
a spacer (170) defining an acoustic port, wherein the first rigid section is attached to a first side of the spacer, and the second rigid section is attached to a second side of the spacer, wherein the first speaker die faces the second speaker die.

2. The package of claim 1, wherein the first rigid section, the second rigid section, and the spacer define an acoustic chamber, wherein sound from the acoustic chamber is directed through the acoustic port defined in the spacer.

3. The package of claim 2, further comprising:
a first cap (230) attached to the first rigid section, wherein the first speaker die is attached to a first side of the first rigid section, wherein the first cap is attached to a second side of the first rigid section, opposite the first side; and
a second cap (240) attached to the second rigid section, wherein the second speaker die is attached to a first side of the second rigid section, wherein the second cap is attached to a second side of the second rigid section, opposite the first side.

4. The package of claim 3, wherein the first cap (230) defines a first cavity between the first cap and the second side of the first rigid section, wherein the second cap (240) defines a second cavity between the second cap and the second side of the second rigid section.

5. The package of claim 4, wherein the first cavity is isolated from the acoustic chamber, and wherein the second cavity is isolated from the acoustic chamber.

6. The package of anyone of claims 1-5, wherein the first rigid section defines a first trench (214) around the first vent aperture, the second rigid section defines a second trench around the second vent aperture, wherein the first speaker die is attached to the first rigid section using a first adhesive (114) deposited in the first trench, and the second speaker die is attached to the second rigid section using a second adhesive (124) deposited in the second trench.

7. The package of anyone of claims 1-6, further comprising:
a third rigid section (130); and
a second flexible section (125) attached between and providing electrical continuity between the first rigid section and the third rigid section.

8. The package of claim 7, further comprising a connector (140) attached to the third rigid section, wherein the connector is in electrical communication with the first speaker die and the second speaker die.

9. The package of claim 7 or 8, wherein the third rigid section comprises electrical leads, wherein the electrical leads are in electrical communication with the first speaker die and the second speaker die.

10. The package of claim 9, wherein a first electrical lead of the electrical leads is in communication with the first speaker die via the second flexible section, and wherein a second electrical lead of the electrical leads is in communication with the second speaker die via the second flexible section and the first flexible section.

11. The package of claim 1, wherein the first speaker die and the second speaker die each comprise a micro-electro-mechanical system, MEMS, speaker die.

12. A method of forming a package comprising:
attaching a first speaker die (116; 118) to a first rigid section (110; 120) over a first vent aperture through the first rigid section;
attaching a second speaker die (118; 116) to a second rigid section (120; 110) over a second vent aperture through the second rigid section, wherein the first rigid section is attached to the second rigid section with a first flexible section;
attaching the first rigid section to a first side of a spacer (170); and
attaching the second rigid section to a second side of the spacer (170) by flexing the first flexible section to form an acoustic chamber between the first rigid section and the second rigid section and bounded by the spacer.

13. The method of claim 12, further comprising:
attaching a first cap (230) to the first rigid section, wherein the first speaker die is attached to a first side of the first rigid section, wherein the first cap is attached to a second side of the first rigid section, opposite the first side; and
attaching a second cap (240) to the second rigid section, wherein the second speaker die is attached to a first side of the second rigid section, wherein the second cap is attached to a second side of the second rigid section, opposite the first side,
wherein the first cap defines a first cavity between the first cap and the second side of the first rigid section, wherein the second cap defines a second cavity between the second cap and the second side of the second rigid section,
wherein the first cavity is isolated from the acoustic chamber, and wherein the second cavity is isolated from the acoustic chamber.

14. A micro-electro-mechanical speaker system comprising:
a first rigid section defining a first vent aperture;
a second rigid section defining a second vent aperture;
a third rigid section;
a first speaker die attached to the first rigid section and covering the first vent aperture;
a second speaker die attached to the second rigid section and covering the second vent aperture;
a first flexible section attached between and providing electrical continuity between the first rigid section and the second rigid section;
a second flexible section attached between and providing electrical continuity between the first rigid section and the third rigid section, wherein electrical connections on the third rigid section are in electrical communication with the first speaker die via the second flexible section and the second speaker die via the first flexible section and the second flexible section; and
a spacer defining an acoustic port, wherein the first rigid section is attached to a first side of the spacer, and the second rigid section is attached to a second side of the spacer, wherein the first speaker die faces the second speaker die.

15. The system of claim 14, wherein the first rigid section, the second rigid section, the third rigid section, the first flexible section, and the second flexible section are formed to be coplanar for attachment of the first speaker die, the second speaker die, and the spacer.
